Europäisches Patentamt

European Patent Office

Office européen des brevets

(11) Veröffentlichungsnummer: **0 414 097 A2**

(12) **EUROPÄISCHE PATENTANMELDUNG**

(21) Anmeldenummer: 90115550.7

(22) Anmeldetag: 14.08.90

(51) Int. Cl.⁵: **H05K 3/10**, H05K 3/42, C25D 5/54

(30) Priorität: 24.08.89 DE 3928435

(43) Veröffentlichungstag der Anmeldung:
27.02.91 Patentblatt 91/09

(84) Benannte Vertragsstaaten:
AT BE CH DE DK ES FR GB GR IT LI LU NL SE

(71) Anmelder: SCHERING AKTIENGESELLSCHAFT
Berlin und Bergkamen
Müllerstrasse 170/178 Postfach 65 03 11
D-1000 Berlin 65(DE)

(72) Erfinder: Majentny, Klaus
Ludolfinger Weg 54a
D-1000 Berlin 28(DE)
Erfinder: Middeke, Hermann-Josef, Dr.
Sächsische Strasse 12
D-1000 Berlin 31(DE)
Erfinder: Meyer, Heinrich, Dr. Dr.habil.
Bismarckstrasse 8b
D-1000 Berlin 39(DE)

(54) Verfahren zur direkten Metallisierung eines nicht leitenden Substrats.

(57) Die Erfindung betrifft ein Verfahren zur direkten Metallisierung eines nicht leitenden Substrats insbesondere zur Herstellung von gedruckten Schaltungen, gekennzeichnet durch die folgenden Verfahrensschritte:
- Vorreinigen, gegebenenfalls Anätzen oder Anquellen der zu metallisierenden Oberfläche
- Belegen der Oberfläche mit einem Adhäsionsmittel
- Adsorption einer Metallverbindung
- Reduktion der Metallverbindung zum Metall
- Galvanische Metallisierung.

# VERFAHREN ZUR DIREKTEN METALLISIERUNG EINES NICHT LEITENDEN SUBSTRATS

Die Erfindung betrifft ein Verfahren gemäß Oberbegriff des Anspruchs 1.

Das Anwendungsgebiet der Erfindung ist die elektrolytische Metallisierung nichtmetallischer Substrate zum Zwecke der Herstellung gedruckter Schaltungen. Die Erfindung bezieht sich auf eine Vereinfachung des Produktionsablaufs und die Erhöhung der Endqualität der Schaltung.

Üblicherweise wird die Durchkontaktiereung solcher Leiterplatten dadurch erzielt, daß das Basismaterial im Sinne der späteren Schaltung gebohrt, und die durch die Bohrung verursachten Rückstände durch einen Reiniger entfernt werden. Diese Reiniger enthalten üblicherweise Zusätze, die die Oberfläche des Substrates konditionieren, um damit die spätere Aktivierung zu erleichtern.

Eine Ätzreinigung säubert im nächsten Verfahrensschritt die Kupferflächen. Darauf erfolgt die Aktivierung in einer Lösung, die auf einer Mischung aus Zinnchlorid, Palladiumchlorid und Salzsäure basiert oder ionogene Aktivatoren. Üblicherweise wird nunmehr in einem Folgeschritt das überschüssige Zinn komplex gebunden und von der Oberfläche entfernt, die im wesentlichen nur noch von inzwischen zu metallischem Palladium reduzierten Metallkeimen belegt ist.

Diese Keime dienen nunmehr in einem chemischen Kupferbad als Kristallisations-und Ausgangspunkt einer homogenen, stromlos aufgetragenen Kupferschicht, die ihrerseits elektrolytisch verstärkt werden kann. Nach dem Auftrag und der Entwicklung des Films (Trockenresist, lösungsmittellöslich oder löslich in wässrigem Alkali) liegt das Schaltbild vor, dessen Aufbau schließlich in einem schwefelsauren elektrolytischen Kupferbad erfolgt.

Nach Erreichen der gewünschten Endschichtdicke kann nach unterschiedlichen Methoden die Endbehandlung zur Erleichterung der Lötung erfolgen.

Es ist zwar weiterhin bereits bekannt, derartige elektrolytische Prozesse unter Vermeidung der stromlosen Metallisierung durchzuführen (US-PS 3.099.608; DE-OS 33 04 004; DE-OS 33 23 476).

Dennoch besteht auch jetzt noch und zwar in immer stärkerem Maße ein erhebliches Bedürfnis in der Praxis, weitere Prozesse dieser Art mit einfacherer und sicherer Prozessführung zur Verfügung zu haben, um insbesondere den gesteigerten Anforderungen der Technik zu entsprechen.

Aufgabe der Erfindung ist daher die Bereitstellung eines Verfahrens, welches die Nachteile der bekannten Verfahren überwindet und die Prozessführung durch Weglassung von Prozeßstufen verbessert.

Diese Aufgabe wird gelöst durch ein Verfahren gemäß dem kennzeichnenden Teil des Patentanspruchs.

Weitere Ausgestaltungen der Erfindung sind den Kennzeichnungsteilen der Unteransprüche zu entnehmen.

Die in der vorliegenden Erfindung beschriebene direkte Galvanisierung vermeidet alle beschriebenen Nachteile. Das Verfahren ist kurz und kommt ohne extreme Temperaturen und hohe Konzentratonen an Komplexbildnern aus. Gegenstand der Erfindung ist es, auf der zu galvanisierenden Oberfläche eine genügend hohe Konzentration an Metall zu erzeugen dadurch, daß zunächst eine wasserunlösliche Haftschicht erzeugt wird, die eine deratige Menge einer Metallverbindung binden kann, daß daraus eine elektrisch leitfähige Schicht erzeugt werden kann. Folgender Ablauf von Arbeitsschritten ist dazu geeignet.

Die elektrische Leitfähigkeit des so auf die Oberfläche gelegten Metalls ist bei geeigneter Wahl der Arbeitsschritte so hoch, daß nun anschließend direkt eine galvanische Metallabscheidung möglich ist.

## Beschreibung der Arbeitsschritte:

Eine Isolierstoff-Oberfläche, vorzugsweise Leiterplattenmaterial wie FR3, FR4, bestehend aus Polymeren wie Epoxid oder Phenol-Harzen oder Poly(imid) oder anderen Polymeren oder ein mit Keramikpatikeln oder Glasfasern gefüllter Komposit-Werkstoff wird zunächst durch Lösungsmittel vorgequollen und/oder durch Tenside gereinigt und benetzbar gemacht oder durch Oxidationsmittel oder Säuren oder ähnliche Medien aufgeschlossen. Dies ist an anderer Stelle detailliert beschrieben und nicht Gegenstand dieser Erfindung.

Anschließend wird die Oberfläche mit einem Hilfsmittel belegt, so daß später eine genügende Menge einer Metallverbindung adsorbiert werden kann. Dies kann ein wasserhaltiges und wasserunlösliches Oxid oder Hydroxid oder Carbonat oder ähnliches sein, das aus der Hydrolyse oder anderen Umsetzungen von Stoffen wie Aluminiumchlorid, Natriumaluminat, Zinn- oder Siliziumhalogeniden oder entsprechenden Titanverbindungen, allgemein auf Basis der Metalle der II. bis IV. Hauptgruppe oder der Nebengruppenelemente auf der zu beschichtenden Oberfläche entwickelt wird oder durch Reduktion entsprechender Stoffe wie zum Beispiel Permanganaten entsteht oder eine andere entsprechend schwerlösliche Verbindung sein, wie zum Beispiel Kalziumoxalat. Der so abgeschiedene Stoff sollte eine gewisse Haftfestigkeit zum Basismaterial aufweisen, hydrophil sein und eine große Oberfläche zur nachfolgenden Adsorption der Metallverbindung haben. Es hat sich als günstig für die nachfolgenden Schritte erwiesen, wenn die in diesem Schritt aufgebrachte Haft- oder Adsorptionsschicht mit Metallverbindungen des Kobalts, Eisens, Nickels oder des Palladiums beziehungsweise anderer ähnlicher Metallverbindungen "dotiert" ist. Die Auftragsparameter richten sich nach dem verwendeten System: wurde Manganoxid ("Braunstein") aus der Reduktion einer Permanganatlösung als Haftvermittler gewählt, so betrug die Permanganatkonzentration zwischen 1 g/l und 150 g/l, bevorzugt jedoch zwischen 10 g/l und 100 g/l, die Lösung wurde mit einem Hydroxid, bevorzugt einem Alkalihydroxid alkalische gemacht, die Hydroxidkonzentration betrug dabei 1,0 g/l bis zu 100 g/l, bevorzugt 5 g/l bis zu 60 g/l Hydroxid. Das Dotierungsmetall wurde der Permanganatlösung als Salz zugesetzt, es kamen bevorzugt Halogenverbindungen, insbesondere Chloride zum Einsatz, die verwendeten Konzentrationen lagen zwischen 0,1 g/l und 50 g/l, bevorzugt jedoch bei 0,5 g/l bis zu 10 g/l. Die Reaktionsdauer betrug eine Minute bis zu 60 Minuten, bevorzugt 2 Minuten bis zu 15 Minuten bei Temperaturen von 0° C bis 120° C, bevorzugt solchen Temperaturen von 20° C vbis 80° C. Hiernach kann ein Ätzreinigungsschritt mit einer Lösung üblicher Zusammensetzung erfolgen.

Im nächsten Schritt wird dann in geeigneter Weise, jedoch vorwiegend durch Tauchen oder Besprühen oder Beschwallen, die Oberfläche mit einer Metallverbindung belegt. Dies können Komplexe der Metalle wie Silber, Gold, Palladium, Platin, Osmium, Iridium oder Rhodium der allgemeinen Foirmel $M_c.(L_x)$-A sein, bei denen $L_x$ einen stickstoffhaltigen organischen oder anorganischen Rest darstellt, x eine ganze Zahl von mindestens 1, vorzugsweise 2 bis 4 und A einen anorganischen oder organischen Säurerest darstellt, wie er für andere Verwendungszwecke bereits in dem Patent DE 2116389 beschrieben ist. Alle dort beschriebenen Stoffe und Verbindungen sind ebenfalls Gegenstand dieser Erfindung, sie haben den Vorteil, daß Metall nicht auf anderen Metallschichten, insbesondere nicht auf der Kupferkaschierung von Leiterplatten abgeschieden wird. Der Metallgehalt der eingesetzten Lösungen liegt zwischen 0,1 g/l und 20 g/l, bevorzugt zwischen 0,5 g/l und 12 g/l, die Auftragstemperatur liegt zweckmäßigerweise zwischen dem Schmelzpunkt und dem Siedepunkt der verwendeten Lösung, vorzugsweise jedoch zwischen 20° C und 60° C, die Reaktionsdauer beim Einwirken kann zwischen einer Sekunde und 60 Minuten liegen, bevorzugt wird eine Reaktionsdauer von einer Minute bis zu zehn Minuten.

Im letzten zu dieser Erfindung gehörigen Schritt wird dann aus der adsorbierten Metallverbindung das freie, elektrisch leitfähige Metall durch Reduktion mit einem geeigneten Reduktionsmittel erzeugt. Dieses können zum Beispiel Aminoborane oder Borhydride oder Aluminiumhydride oder verwandte ähnliche Reduk tionsmittel leisten, wie Natriumborhydrid oder Dimethylaminoboran oder Lithiumaluminiumhydrid, Natriumhypophosphit, Hydrazin, Hydroxilammoniumchlorid in geeigneten Lösungen und Konzentrationen. Die Konzentrationen sind unkritisch, sie liegen zwischen 0,2 g/l und 50 g/l, bevorzugt jedoch zwischen 0,5 g/l und 10 g/l des Reduktionsmittels, die Temperaturen liegen zwischen 0° C und 120° C, bevorzugt zwischen 20° C und 60° C, die Einwirkungs-beziehungsweise Reduktionsdauer sollte zwischen 5 Sekunden und 60 Minuten liegen, vorzugsweise zwischen einer Minute und zehn Minuten.

Im Anschluß an die Reduktion der Metallverbindung zum Metall kann direkt in einem handelsüblichen galvanischen Bad metallisiert werden.

Unter nichtleitenden Substraten versteht man zum Beispiel glasfaserverstärktes Epoxidharz, Keramik, Polyimid, Polytetrafluorethylen (PTFE), Phenolharz, Bismaleimid-Triazin (BT), Teflon-Polysulfon und andere.

Das erfindungsgemäße Verfahren ermöglicht daher in technisch einfacher Weise die Qualitätsförderung des Endprodukts, da der Aufbau einer ersten, chemisch abgeschiedenen, strukturell zwangsläufig andersgearteten Kupferschicht vor dem Aufbau der elektrolytisch aufgetragenen Kupferschicht entfallen kann.

Alle vorgenannten Arbeitsschritte können durch Tauchen oder Besprühen oder Beschwallen durchgeführt werden.

Die folgenden Beispiele dienen zur Erläuterung der Erfindung.

BEISPIEL 1

Ein Stück FR4-Material wurde nach dem Reinigen in einer geeigneten Tensidlösung und nachfolgendem Spülen fünf Minuten in eine Lösung aus 60 g/l $KMnO_4$, 30 g/l NaOH, 10 g/l $NaH_2PO_4$, 500 ppm Palladium und 2 ml/l Netzmittel G13 bei 65° C gebracht. Die Platte wurde anschließend mit Wasser gespült und dann ebenfalls fünf Minuten bei Raumtemperatur in eine Lösung aus einem Palladiumkomplex mit einem aromatischen Amin, gelöst in verdünnter Schwefelsäure gegeben (Pd-Gehalt: 5 g/l; pH-Wert etwa 1,5). Nach anschließendem Spülen wurde der Belag auf der Plattenoberfläche durch Eintauchen in eine Lösung aus 5 g/l NaOH und 2 g/l $NaBH_4$ zu metallischem Palladium reduziert. Die Platte konnte danach in einem handelsüblichen sauren Kupferelektrolyten (Stromdichte: 2-5 $A/dm^2$) ganzflächig verkupfert werden.

## BEISPIEL 2

Wie Beispiel 1. Hier wurde jedoch gebohrtes, kupferkaschiertes Multilayermaterial eingesetzt. Die Bohrlochwandungen waren bereits nach 15 Sekunden dicht verkupfert. Es konnten keine Fehler in der Metallbelegung nachgewiesen werden. Die Multilayer-Innenlagen waren fehlerfrei ankontaktiert. Auf der Kupferkaschierung waren per EDX weder Mangan noch Palladium nachweisbar.

## BEISPIEL 3

Wie Beispiel 2, jedoch mit FR3 (Epoxid/Papier) als Basismaterial.

## BEISPIEL 4

Wie Beispiel 2, jedoch mit einer Lösung des Palladiumkomplexes mit nur 2,5 g/l Palladiumgehalt. Es konnten keine Unterschiede im Ergebnis zu Beispiel 1 gefunden werden.

## BEISPIEL 5

Wie in Beispiel 1, jedoch wurde Leiterplattenmaterial mit sehr hohem Aspektverhältnis zur Metallisierung eingesetzt. die 6 mm dicke Platte wies Löcher mit Durchmessern von 0,3 mm auf. Die Löcher und der Rand der Platte waren nach spätestens 30 Sekunden komplett verkupfert.

## BEISPIEL 6

Wie Beispiel 4, jedoch mit einem Palladiumgehalt der Pd-Komplex-Lösung von nur noch 1,0 g/l. Die Behandlungstemperatur in dieser Lösung wurde auf 35° C gesteigert.

## Ansprüche

1. Verfahren zur direkten Metallisierung eines nicht leitenden Substrats insbesondere zur Herstellung von gedruckten Schaltungen, gekennzeichnet durch die folgenden Verfahrensschritte:
- Vorreinigen, gegebenenfalls Anätzen oder Anquellen der zu metallisierenden Oberfläche
- Belegen der Oberfläche mit einem Adhäsionsmittel
- Adsorption einer Metallverbindung
- Reduktion der Metallverbindung zum metall
- Galvanische Metallisierung.
2. Verfahren gemäß Anspruch 1, dadurch gekennzeichnet, daß als Adhäsionsmittel ein wasserhaltiges und/oder wasserunlösliches Metalloxyd, Metallhydroxid oder Metallcarbonat verwendet wird.

3. Verfahren gemäß Anspruch 2, dadurch gekennzeichnet, daß es sich um Hydrolyseprodukte oder Umsetzungsprodukte von Aluminiumchlorid, Natriumaluminat, Zinn- oder Siliziumhalogeniden, Titanverbindungen oder Verbindungen auf Basis der Metalle der II. bis IV. Hauptgruppe oder der Nebengruppenelemente handelt.

4. Verfahren gemäß Anspruch 2, dadurch gekennzeichnet, daß es sich um Reduktionsprodukte von reduzierbaren Stoffen, vorzugsweise von Permanganaten, wie Kaliumpermanganat und/oder Natriumpermanganat handelt.

5. Verfahren gemäß Anspruch 4, dadurch gekennzeichnet, daß das Reduktionsprodukt Braunstein darstellt.

6. Verfahren gemäß Anspruch 2, dadurch gekennzeichnet, daß es sich um Kalziumoxalat handelt.

7. Verfahren gemäß Anspruch 1, dadurch gekennzeichnet, daß das Adhäsionsmittel entweder gemeinsam oder in einem darauffolgenden Schritt mit Metallverbindungen des Kobalts, Nickels, Eisens und/oder Palladiums auf die zu metallisierende Oberfläche aufgebracht wird.

8. Verfahren gemäß Anspruch 1, dadurch gekennzeichnet, daß für die Adsorption Metallverbindungen verwendet wird, die Komplexe der Metalle M wie Silber, Gold, Palladium, Platin, Osmium, Iridium oder Rhodium der allgemeinen Formel $M_c$-$(L_x)$-A, bei der $L_x$ einen stickstoffhaltigen organischen oder anorganischen Rest darstellt, x eine ganze Zahl von mindestens 1, vorzugsweise 2 bis 4 und A einen anorganischen oder organischen Säurerest darstellt.

9. Verfahren gemäß Anspruch 1, dadurch gekennzeichnet, daß die Reduktion zum Metall mittels Aminoboranen, Borhydriden oder Aluminiumhydriden vorzugsweise Natriumborhydrid, Dimethylaminoboran oder Lithiumaluminiumhydrid, Natriumhypophosphit, Hydrazin, Hydroxilammoniumchlorid in geeigneten Lösungen und Konzentrationen vorgenommen wird.

10. Verfahren gemäß Anspruch 1, dadurch gekennzeichnet, daß zur galvanischen Metallabscheidung galvanische Metallisierungsbäder, wie Kupfer- oder Nickelbäder, verwendet werden.

11. Verfahren gemäß Anspruch 1 ohne Verwendung stromloser Metallisierungsbäder.